# EUROPÄISCHE PATENTANMELDUNG

(11) **EP 0 572 878 A1**
(43) Veröffentlichungstag der Anmeldung: **08.12.1993**
(21) Anmeldenummer: 93108264.8
(22) Anmeldetag: 21.05.1993
(51) Int. Cl.: H05K 13/00, B65G 17/26

(54) **Vorrichtung zum vorzugsweise geradlinigen Transport von Teilen, Werkstücken oder dergl.**

(30) Priorität: 02.06.1992 DE 4218033
(71) Anmelder: CENTROTHERM ELEKTRISCHE ANLAGEN GMBH + CO., D-89143 Blaubeuren (DE)
(72) Erfinder: Schmid, Bernhard, W-7900 Ulm/ Donau (DE)
(74) Vertreter: Dziewior, Joachim, Dipl.-Phys. Dr.

(57) **Zusammenfassung**

Die Vorrichtung dient zum vorzugsweise geradlinigen Transport von Teilen, Werkstücken oder dergl., insbesondere von elektrischen Leiterplatten, und ist mit wenigstens zwei, parallel und mit Abstand zueinander geführten, vorzugsweise endlosen Transportbändern 1, 2 versehen, auf denen die Teile vorzugsweise mit ihrem Rand aufliegen. Die Transportbänder 1, 2 laufen über jeweils auf einer gemeinsamen Welle 6, 7 angeordnete Umlenk- bzw. Führungsrollen 4, 5 ab. Jede der Wellen 6, 7 ist als Gewindespindel mit untereinander gleicher Gewindesteigung ausgebildet. Die Umlenk- bzw. Führungsrollen 4, 5 sind mit einem entsprechenden Innengewinde versehen, wobei die Umlenk- bzw. Führungsrollen 4, 5 auf der Gewindespindel während des Transportbetriebes drehfest angeordnet, zur Verstellung ihres gegenseitigen Abstandes gegenüber der Gewindespindel jedoch verdrehbar sind. Die Transportbänder 1, 2 sind schlupffrei an die Umlenk- bzw. Führungsrollen 4, 5 gekoppelt.

## Beschreibung

Die Erfindung betrifft eine Vorrichtung zum vorzugsweise geradlinigen Transport von Teilen, Werkstücken oder dergl., insbesondere von elektrischen Leiterplatten, mit wenigstens zwei, parallel und mit Abstand zueinander geführten, vorzugsweise endlosen Transportbändern, auf denen die Teile vorzugsweise mit ihrem Rand aufliegen und die über jeweils auf einer gemeinsamen Welle angeordnete Umlenk- bzw. Führungsrollen ablaufen.

Anwendung finden derartige Vorrichtungen u. a. bei der Herstellung von beidseitig zu bestückenden Leiterkarten, die Temperaturprozessen in Reflow- und Trockenöfen unterworfen werden müssen. Zur Handhabung dieser Leiterkarten wird ein Transportsystem benötigt, das nur an den Seiten der Leiterkarte Auflageflächen aufweist. Diese Transportart wird als Fingertransport bezeichnet. Hierzu sind an den Transportbändern seitlich kleine Auflagezapfen vorgesehen, die zum Transportraum hin weisen. In der Regel bilden zwei Transportbänder gemeinsam eine Transportspur. Es können jedoch, insbes. beim Transport anderer Teile, auch mehr als zwei Transportbänder vorgesehen sein, insbes. dann, wenn die Teile auch in ihrem Mittelbereich einer Unterstützung bedürfen.

In jedem Fall ist es notwendig, den Abstand der jeweils beiden äußeren Transportbänder auf die Breite der zu transportierenden Teile anzupassen.

Dies kann in einfachster Weise dadurch geschehen, daß die Umlenk- bzw. Führungsrollen an der Welle gelöst und in axialer Richtung entsprechend der gewünschten Führungsbreite verschoben werden. Bei sehr langen Transportspuren, die zwischen ihren beiden Enden zusätzliche Führungsrollen aufweisen, um die parallele Führung der Transportbänder auch im Mittelbereich der Transportspur sicherzustellen, bedarf die Umstellung der Transportbreite zeitaufwendiger Umrüst- und Justierarbeiten, wobei erschwerend hinzukommt, daß diese Führungsrollen, soweit sie sich im Ofenbereich oder dergl. befinden, häufig schwer zugänglich sind.

Der Erfindung liegt die Aufgabe zugrunde, eine Vorrichtung der eingangs genannten Art so auszubilden, daß die Transportbreite auf einfache Weise, gegebenenfalls sogar selbsttätig auf die jeweils notwendige Nutzbreite eingestellt werden kann, wobei weiter gewährleistet sein soll, daß eine gleichmäßige Verstellung der Breite über die gesamte Länge der Transportspur erfolgt.

Diese Aufgabe wird nach der Erfindung dadurch gelöst, daß jede der Wellen als Gewindespindel mit untereinander gleicher Gewindesteigung ausgebildet ist und die Umlenk- bzw. Führungsrollen mit einem entsprechenden Innengewinde versehen sind, wobei die Umlenk- bzw. Führungsrollen auf der Gewindespindel während des Transportbetriebes drehfest angeordnet, zur Verstellung ihres gegenseitigen Abstandes gegenüber der Gewindespindel jedoch verdrehbar sind und die Transportbänder schlupffrei an die Umlenk- bzw. Führungsrollen gekoppelt sind.

Der durch die Erfindung erreichte Vorteil besteht zunächst darin, daß die Verstellung der Transportbreite allein durch eine Relativbewegung der Transportbänder gegeneinander erreicht wird. Je nach Drehrichtung des einen Transportbandes gegenüber dem anderen wird dadurch eine Vergrößerung bzw. Verkleinerung der Transportbreite erreicht. Da über das Transportband gleichzeitig sämtliche mit dem Transportband in Verbindung stehenden Umlenk- bzw. Führungsrollen verstellt werden, erfolgt eine absolut gleichförmige Änderung der Führungsbreite.

Weiter ist von Vorteil, daß die Änderung der Führungsbreite grundsätzlich an jeder beliebigen Stelle der Transportbänder vorgenommen werden kann, so daß der Einsatz der Vorrichtung selbst in völlig unzugänglichen Einrichtungen möglich ist. In der Regel wird die Verstellung der Transportbreite jedoch mit dem ohnehin vorgesehenen Antriebsmotor erfolgen, wozu beispielsweise das eine Transportband gebremst und das andere durch den Antriebsmotor in der einen oder anderen Drehrichtung verstellt werden kann. Sofern für den Antrieb ein Schrittmotor verwendet wird, besteht bei Kenntnis der Gewindesteigung der Gewindespindel sogar die Möglichkeit, die Transportbreite selbsttätig einzustellen.

In bevorzugter Ausführungsform sind die Transportbänder als Transportgliederketten ausgebildet, wobei für die Umlenk- bzw. Führungsrollen dann Kettenradscheiben vorgesehen sind. Ebenso besteht jedoch auch die Möglichkeit, die Transportbänder als Zahnriemen auszubilden.

In besonders einfacher Ausführungsform der Erfindung sind die Umlenk- bzw. Führungsrollen eines der Transportbänder stets drehfest mit der Welle verbunden. In diesem Fall liegt der eine Rand der Transportspur stets in axialer Richtung der Wellen fest, so daß allein der andere Rand einstellbar ist.

Es ist jedoch ebenso möglich, alle Umlenk- bzw. Führungsrollen verdrehbar auf der Gewindespindel anzuordnen, so daß auch eine auf die Mitte zentrierte Änderung der Breite einer Transportspur möglich ist.

In weiter bevorzugter Ausführungsform der Erfindung ist vorgesehen, daß wenigstens eine Umlenk- bzw. Führungsrolle jeweils eines Transportbandes zur Verdrehung gegenüber der Welle mit einer Bremseinrichtung versehen ist. Hierdurch besteht die Möglichkeit, das zu verstellende Transportband anzuhalten, während die einzelnen Wellen über beispielsweise den Antriebsmotor und ein anderes Transportband in Drehung versetzt werden, wodurch sich die axiale Verstellung der Umlenk- bzw. Führungsrollen auf der Welle ergibt.

Um eine unbeabsichtigte Verstellung der Umlenk- bzw. Führungsrollen zu vermeiden, sieht die Erfindung vor, daß wenigstens eine Umlenk- bzw. Führungsrolle jeweils eines Transportbandes zur drehfesten Verbindung mit der Welle mit einer Kupplungseinrichtung versehen ist.

Es besteht jedoch auch die weiter vorteilhafte Möglichkeit, daß eine mit wenigstens einer, schlupffrei an das Transportband gekoppelten Kupplungsrolle versehene Kupplungswelle vorgesehen ist, an der eine Bremseinrichtung und/oder eine Kupplungseinrichtung zur Antriebsseite hin angeschlossen ist. Dann besteht die Möglichkeit, die Breitenveränderung der Transportspur über die Kupplungswelle vorzunehmen, die in diesem Fall als Keilwelle ausgebildet sein kann.

Um einen möglichst einfachen und stabilen Aufbau zu erreichen, ist es von Vorteil, wenn die jeweils die Transportbänder endseitig umlenkenden Umlenk- bzw. Führungsrollen gemeinsam mit der Kupplungsrolle auf einer Montageplatte angeordnet sind. In diesem Fall kann wiederum eine der Montageplatten feststehend ausgebildet sein, während die andere Montageplatte der Breitenverstellung der Transportspur folgt. Dann besteht weiter die Möglichkeit, daß an der Montageplatte zusätzlich ein Spannrad für das Transportrad vorgesehen ist, das zwischen den beiden, für den hin- und rücklaufenden Teil des Transportbandes jeweils eigens vorgesehenen Umlenk- bzw. Führungsrollen angeordnet ist.

Im folgenden wird die Erfindung an einem in der Zeichnung dargestellten Ausführungsbeispiel näher erläutert; es zeigen:
- Fig.: 1 eine schematische Darstellung der Vorrichtung in perspektivischer Ansicht,
- Fig. 2: eine Draufsicht auf den Endbereich einer Transportspur,
- Fig. 3: eine Seitenansicht des Gegenstandes nach Fig. 2 in Richtung III,
- Fig. 4: eine Seitenansicht des Gegenstandes nach Fig. 2 in Richtung IV,
- Fig. 5: einen Querschnitt durch den Gegenstand nach Fig. 3 längs der Linie A - A,
- Fig. 6: einen Querschnitt durch den Gegenstand nach Fig. 4 längs der Linie D - D.

Die in der Zeichnung dargestellte Vorrichtung dient zum Transport von Teilen, Werkstücken oder dergl. und ist dazu mit zwei parallel und mit Abstand zueinander geführten Transportbändern 1, 2 versehen, die als Transportgliederketten ausgebildet sind. Derartige Vorrichtungen werden beispielsweise dazu eingesetzt, um beidseitig bestückte Leiterkarten Temperaturprozessen in Reflow- und Trockenöfen zuführen zu können. Da es hierbei erforderlich ist, die Auflagefläche der Leiterkarten auf den Transportbändern 1, 2 minimal zu halten, sind die Transportgliederketten mit kleinen Auflagezapfen 3 versehen, die zum Transportraum hin vorstehen. Die zu transportierenden Teile, also beispielsweise die Leiterkarten, liegen dadurch lediglich mit ihrem Rand auf den Transportbändern 1, 2 bzw. den Auflagezapfen 3 auf.

Die in der Regel endlosen Transportbänder 1, 2 laufen über jeweils auf einer gemeinsamen Welle 6, 7 angeordnete Umlenk- bzw. Führungsrollen 4, 5 ab.

Um die Transportbreite, also den gegenseitigen Abstand der Transportbänder 1, 2 an die jeweilige Breite der zu transportierenden Teile anpassen zu können, ist jede der Wellen 4, 5 als Gewindespindel mit untereinander gleicher Gewindesteigung ausgebildet. Die Umlenk- bzw. Führungsrollen 1, 2 sind mit einem entsprechenden Innengewinde versehen, wobei die Umlenk- bzw. Führungsrollen 4, 5 auf der Gewindespindel während des Transportbetriebes drehfest angeordnet sind. Solange sich daher die Umlenk- bzw. Führungsrollen 4, 5 mit gleicher Winkelgeschwindigkeit wie die sie antreibende Gewindespindel drehen, findet der übliche Transportvorgang statt.

Wird dagegen das eine Transportband 2 gegenüber dem anderen verstellt, so ändert sich der gegenseitige Abstand der Umlenk- bzw. Führungsrollen 4, 5 auf der Gewindespindel. Je nach gegenseitiger Drehrichtung kann hierbei eine Vergrößerung oder Verkleinerung des Abstandes der Transportbänder 1, 2 voneinander erreicht werden. Diese Verstellung kann beispielsweise dadurch erfolgen, daß das eine Transportband 2 zum Stillstand abgebremst wird, während das andere Transportband 1 durch den Antriebsmotor in der einen oder anderen Drehrichtung bewegt wird, bis der gewünschte gegenseitige Abstand der Transportbänder 1, 2 sich einstellt. Hierzu können insbes. die Umlenk- bzw. Führungsrollen 4, 5 des einen Transportbandes 1 stets drehfest mit der Welle 6, 7 verbunden sein, wodurch auch der durch dieses Transportband 1 bestimmte Rand der Transportspur grundsätzlich festgelegt ist. Lassen sich dagegen die Umlenk- bzw. Führungsrollen 4, 5 beider Transportbänder 1, 2 gegenüber der Gewindespindel verdrehen, kann die Lage der Transportspur über die gesamte Länge der Welle 6, 7 hin frei eingestellt werden.

Da die Transportbänder 1, 2 schlupffrei an die Umlenk- bzw. Führungsrollen 4, 5 gekoppelt sind, erfolgt eine Veränderung der Transportspurbreite gleichzeitig für sämtliche Umlenk- bzw. Führungsrollen 4, 5 des jeweiligen Transportbandes 1, 2. Dies ist insbes. dann von Vorteil, wenn die Transportspur eine so große Länge hat, daß zusätzlich zu den jeweils im Endbereich vorgesehenen Umlenkrollen 4, 5 weitere Führungsrollen über die Länge der Transportspur verteilt angeordnet sind, die für die erforderliche Parallelität der Transportbänder 1, 2 sorgen. Im Ergebnis reduziert sich die Einstellung einer anderen Transportspurbreite darauf, die beiden Transportbänder 1, 2 über eine bestimmte Länge gegenseitig zu verstellen. Diese Aufgabe kann bei bekannter Gewindesteigung der Gewindespindel und der Verwendung eines Schrittmotors als Antriebsmotor auch automatisch gesteuert ausgeführt werden. Hierfür kann wenigstens eine Umlenk- bzw. Führungsrolle 4, 5 des zu verstellenden Transportbandes 1, 2 zur Verdrehung gegenüber der Welle 6, 7 mit einer Bremseinrichtung 8 versehen sein, über die dieses Transportband 1, 2 im Stillstand gehalten werden kann, während der Antriebsmotor über das andere Transportband 1, 2 die einzelnen Wellen antreibt. Hierbei ist es weiter empfehlenswert, wenn wenigstens eine Umlenk- bzw. Führungsrolle 4, 5 jeweils eines Transportbandes 1, 2 zur drehfesten Verbindung mit der Welle 6, 7 mit einer Kupplungseinrichtung 9 versehen ist.

Bei dem in der Zeichnung dargestellten Ausführungsbeispiel ist zusätzlich eine mit einer schlupffrei an das Transportband 2 gekoppelten Kupplungsrolle 10 versehene Kupplungswelle 11 vorgesehen, an der eine Bremseinrichtung 8 sowie eine Kupplungseinrichtung 9 zur Antriebsseite hin angeschlossen ist.

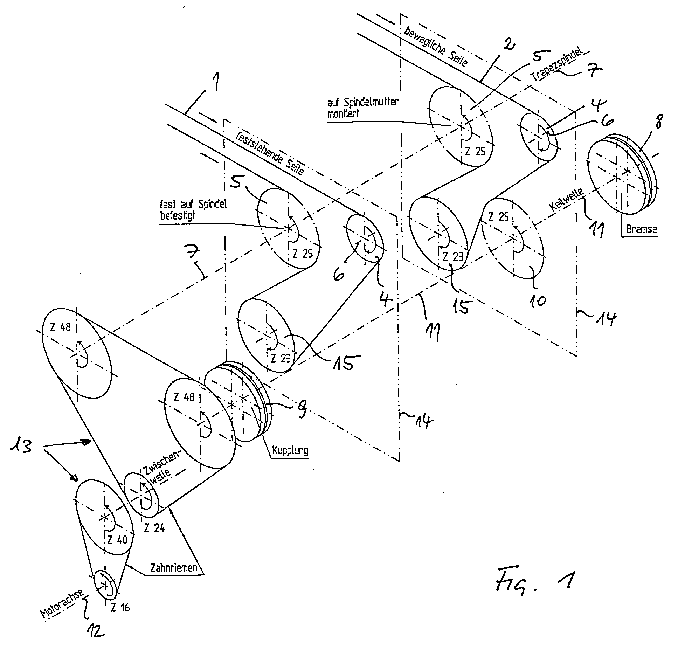

Der in Fig. 1 lediglich durch die Achse 12 angedeutete Motor treibt über ein Untersetzungsgetriebe 13 einerseits die als Gewindespindel ausgebildete Welle 7 sowie die Kupplungswelle 11 an, die über die Kupplungseinrichtung 9 zu- oder abschaltbar ist. Solange die Kupplung 9 sich in eingekuppeltem Zustand befindet, wird die Kupplungswelle 11 angetrieben mit dem Ergebnis, daß beide Transportbänder 1, 2 mit gleicher Geschwindigkeit laufen, der gegenseitige Abstand der Umlenk- bzw. Führungsrollen 4, 5 also erhalten bleibt. Wird dagegen die Kupplungseinrichtung 9 gelöst und die Bremseinrichtung 8 betätigt, so kommt das eine Transportband 2 zum Stillstand, während das andere Transportband 1 durch den Motor weiter angetrieben wird. Entsprechend der Drehrichtung des Motors kommt es dann zu einer Verstellung des gebremsten Transportbandes 2 in axialer Richtung der Wellen 6, 7.

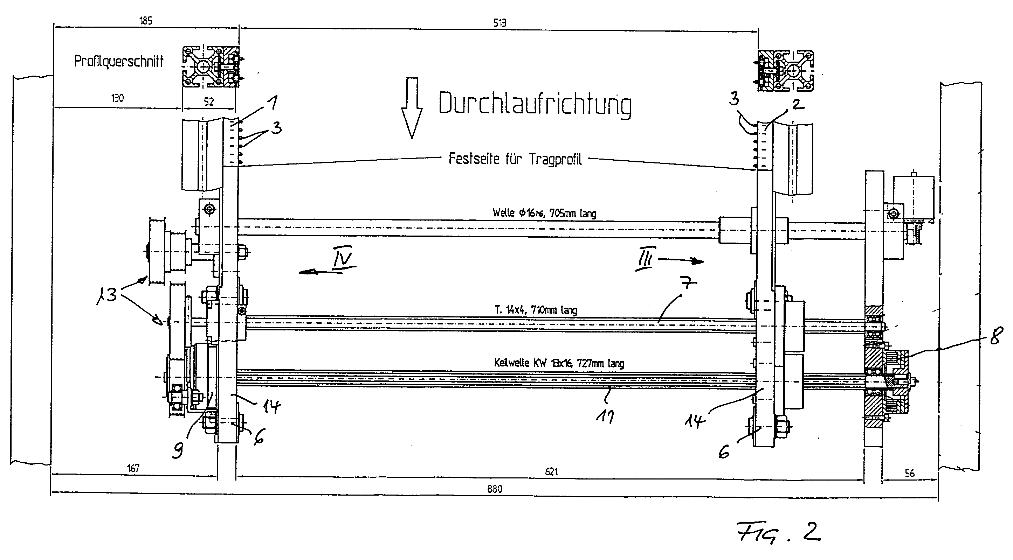

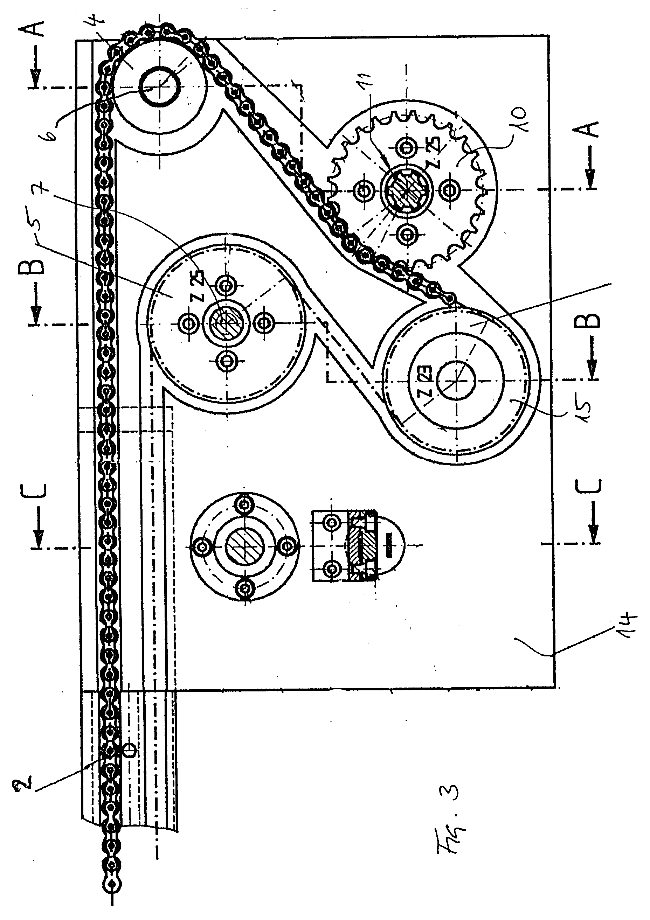

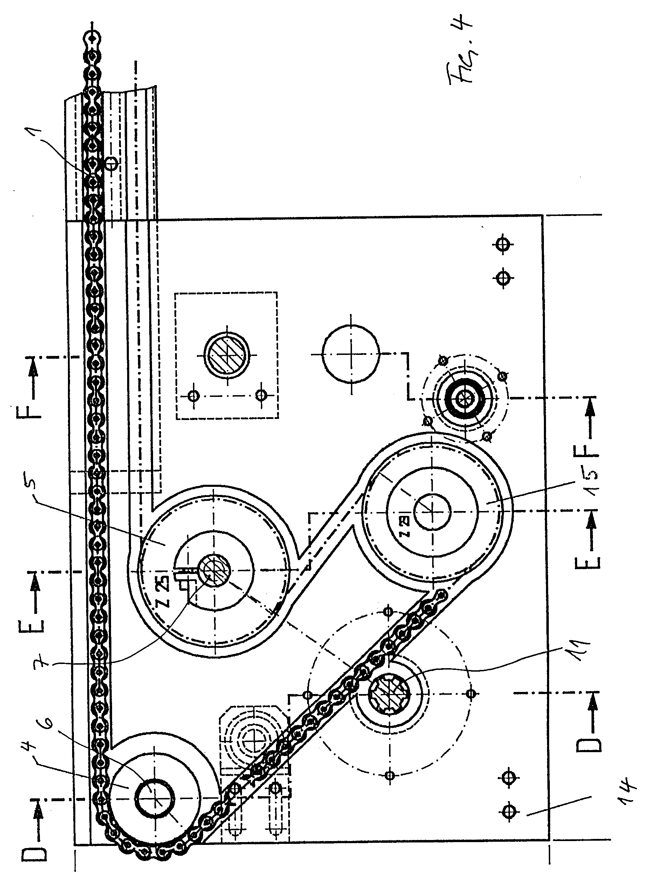

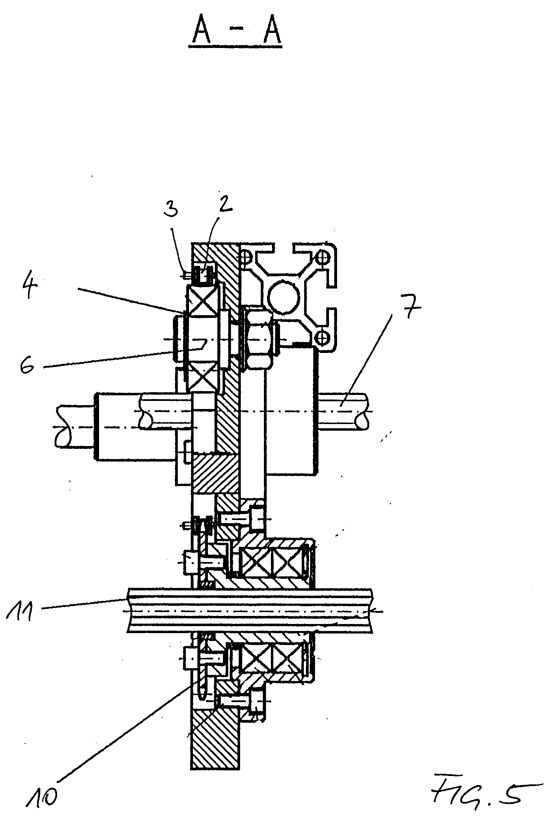

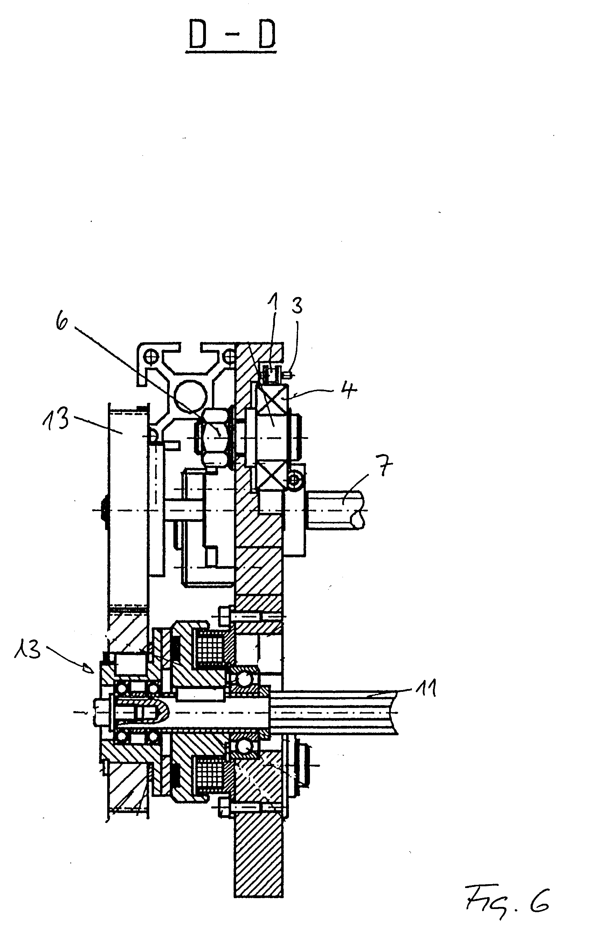

Die jeweils die Transportbänder 1, 2 endseitig umlenkenden Umlenk- bzw. Führungsrollen 4, 5 sind, wie die Fig. 2 bis 4 erkennen lassen, gemeinsam mit der Kupplungsrolle 10 auf einer Montageplatte 14 angeordnet. Dabei ist die in der Fig. 1 links dargestellte Montageplatte 14 feststehend, während die rechte Montageplatte 14 der Breite der Führungsspur entsprechend folgt. Dabei ist an jeder Montageplatte 14 zusätzlich ein Spannrad 15 für das Transportband 1, 2 vorgesehen, das zwischen den beiden, für den hin- und rücklaufenden Teil des Transportbandes 1, 2 jeweils eigens vorgesehenen Umlenk- bzw. Führungsrollen 4, 5 angeordnet ist. Durch die Anbringung der Umlenk- bzw. Führungsrollen 4, 5 auf der Montageplatte 14 ist es ausreichend, nur eine der Wellen 6, 7, nämlich die Welle 7 als Gewindespindel auszubilden, während die Welle 6, wie in den Fig. 5 und 6 zu sehen, als von der Montageplatte 14 vorstehender Lagerzapfen ausgebildet sein kann.

In den Fig. 2 und 6 ist jeweils links das Antriebsgetriebe erkennbar, an das ein in der Zeichnung nicht näher dargestellter Antriebsmotor anschließbar ist.

## Patentansprüche

1. Vorrichtung zum vorzugsweise geradlinigen Transport von Teilen, Werkstücken oder dergleichen, insbesondere von elektrischen Leiterplatten, mit wenigstens zwei, parallel und mit Abstand zueinander geführten, vorzugsweise endlosen Transportbändern (1, 2), auf denen die Teile vorzugsweise mit ihrem Rand aufliegen und die über jeweils auf einer gemeinsamen Welle (6, 7) angeordnete Umlenk- bzw. Führungsrollen (4, 5) ablaufen, dadurch gekennzeichnet, daß jede der Wellen (6, 7) als Gewindespindel mit untereinander gleicher Gewindesteigung ausgebildet ist und die Umlenk- bzw. Führungsrollen (4, 5) mit einem entsprechenden Innengewinde versehen sind, wobei die Umlenk- bzw. Führungsrollen (4, 5) auf der Gewindespindel während des Transportbetriebes drehfest angeordnet, zur Verstellung ihres gegenseitigen Abstandes gegenüber der Gewindespindel jedoch verdrehbar sind und die Transportbänder (1, 2) schlupffrei an die Umlenk- bzw. Führungsrollen (4, 5) gekoppelt sind.

2. Vorrichtung nach Anspruch 1, dadurch gekennzeichnet, daß die Transportbänder (1, 2) als Transportgliederketten ausgebildet sind.

3. Vorrichtung nach Anspruch 1, dadurch gekennzeichnet, daß die Transportbänder (1, 2) als Zahnriemen ausgebildet sind.

4. Vorrichtung nach einem der Ansprüche 1 bis 3, dadurch gekennzeichnet, daß die Umlenk- bzw. Führungsrollen (4, 5) eines der Transportbänder (1,2) stets drehfest mit der Welle(6,7) verbunden sind.

5. Vorrichtung nach einem der Ansprüche 1 bis 4, dadurch gekennzeichnet, daß wenigstens eine Umlenk- bzw. Führungsrolle (4, 5) jeweils eines Transportbandes (1, 2) zur Verdrehung gegenüber der Welle (6, 7) mit einer Bremseinrichtung (8) versehen ist.

6. Vorrichtung nach einem der Ansprüche 1 bis 5, dadurch gekennzeichnet, daß wenigstens eine Umlenk- bzw. Führungsrolle (4, 5) jeweils eines Transportbandes (1, 2) zur drehfesten Verbindung mit der Welle (6, 7) mit einer Kupplungseinrichtung (9) versehen ist.

7. Vorrichtung nach einem der Ansprüche 1 bis 4, dadurch gekennzeichnet, daß eine mit wenigstens einer, schlupffrei an das Transportband (1,2) gekoppelten Kupplungsrolle (10) versehene Kupplungswelle (11) vorgesehen ist, an der eine Bremseinrichtung (8) und/oder eine Kupplungseinrichtung (9) zur Antriebsseite hin angeschlossen ist.

8. Vorrichtung nach Anspruch 7, dadurch gekennzeichnet, daß die jeweils die Transportbänder (1, 2) endseitig umlenkenden Umlenk- bzw. Führungsrollen (4, 5) gemeinsam mit der Kupplungsrolle (10) auf einer Montageplatte (14) angeordnet sind.

9. Vorrichtung nach Anspruch 8, dadurch gekennzeichnet, daß an der Montageplatte (14) zusätzlich ein Spannrad 15 für das Transportband (1, 2) vorgesehen ist, das zwischen den beiden, für den hin- und rücklaufenden Teil des Transportbandes (1, 2) jeweils eigens vorgesehenen Umlenk- bzw. Führungsrollen (4, 5) angeordnet ist.
